Europäisches Patentamt

(19) European Patent Office

Office européen des brevets

(11) Publication number: **0 243 070**
A2

(12) # EUROPEAN PATENT APPLICATION

(21) Application number: 87303253.6

(22) Date of filing: 14.04.87

(51) Int. Cl.³: **H 01 L 29/207**
//H01L43/14

(30) Priority: 15.04.86 JP 86760/86
24.10.86 JP 253466/86

(43) Date of publication of application:
28.10.87 Bulletin 87/44

(84) Designated Contracting States:
DE FR GB NL

(71) Applicant: MITSUBISHI MONSANTO CHEMICAL CO. LTD.
5-2, Marunouchi 2-chome Chiyoda-ku
Tokyo(JP)

(71) Applicant: MITSUBISHI CHEMICAL INDUSTRIES LIMITED
5-2, Marunouchi 2-chome Chiyoda-ku
Tokyo 100(JP)

(72) Inventor: Yamada, Yutaka
29-8 Sakuragaoka
Tsuchiura-chi, Ibaraki(JP)

(72) Inventor: Ibuka, Toshihiko
4006-3 Wakamatsu
Tsuchiura-shi, Ibaraki(JP)

(72) Inventor: Orito, Fumio
29-10 Sakuragaoka
Tsuchiura-shi, Ibaraki(JP)

(72) Inventor: Seta, Yuichi
2-7-3 Ogawa
Machida-shi, Tokyo(JP)

(74) Representative: Paget, Hugh Charles Edward et al,
MEWBURN ELLIS & CO. 2/3 Cursitor Street
London EC4A 1BQ(GB)

(54) Semiconductor device of III-V compound.

(57) In a III-V compound semiconductor device, the concentration of boron contaminated into a single crystalline III-V compound is set as $1 \times 10^{17}$ cm$^{-3}$ or less, thereby increasing the activation ratio of iron-implanted impurities in the device and lessening the dispersion of the activation ratio.

EP 0 243 070 A2

# SEMICONDUCTOR DEVICE OF A III-V COMPOUND

BACKGROUND OF THE INVENTION

1. Field of the Invention

The present invention relates to a semiconductor device, in which a single crystalline substrate consisting of an inorganic compound of a IIIb group element and a Vb group element of the Periodic Table (hereinafter referred to as III-V compound) is homogeneous and exhibits improved properties.

2. Description of the Related Art

The single crystals of III-V compounds, such as gallium arsenide and indium phosphide, have a high carrier mobility and thus are widely used as the substrate of semiconductor devices, such as field-effect transistors used for amplification or oscillation in the SHF band, analog ICs, and high speed digital ICs, for example, logic gates using field effect transistors.

In the fabrication of the above semiconductor devices, the techniques of epitaxial growth, ion-implantation, and the like are employed. Epitaxial growth is, however, inferior to ion-implantation in the productivity and yield of semiconductor devices, and thus the latter is now more frequently used than the former.

In the ion-implantation technique for fabricating a semiconductor device, conductive impurity ions are implanted into a single crystalline substrate of a semi-insulating III-V compound, and the implanted ions are activated by annealing. This annealing is carried out by holding the ion-implanted substrate at a high temperature for a required period of time in an atmosphere containing a Vb group element, or the substrate may be covered with a film of silicon nitride-film to prevent the loss of the Vb group element from the substrate (c.f. "Compound Semiconductor Device II" (in Japanese) published by Kogyo Chosa Kai (Industrial Research Association) pages 1 ∿ 95).

The conventional ion-implantation techniques involved problems in that the ratio of activation of implanted impurity ions due to annealing varies between the implantation lots and varies locally even within an identical substrate.

Particularly, with regard to the single crystal, which is grown by the fully encapsulated Czochralsky method, (hereinafter referred to as the "FEC method") in which a grown single crystal is located in the encapsulant until the completion of solidification of at least the straight part thereof, to prevent exposure to a high-temperature atmosphere (c.f. Japanese Unexamined Patent Publication No. 58-135626), the problem has arisen in which the etch pit density is small but the variation in activation ratio is great between the crystals. The characteristics of semiconductor devices produced by using the substrates as described above vary, with the result that the yield of ICs composed of a number of components is considerably lowered.

SUMMARY OF THE INVENTION

An object of the present invention is to uniformalize the activation ratio of implanted impurity ions, and thus enhance the yield of semiconductor devices.

In accordance with the objects of the present invention, there is provided a semiconductor device, comprising a single crystalline substrate of a semi-insulating III-V compound, and regions of the single crystalline substrate with conductive impurities which are ion-implanted and then activated by annealing, characterized in that the concentration of boron contained in the single crystalline substrate does not exceed $1 \times 10^{17}$ cm$^{-3}$.

The single crystalline substrate of the III-V compound used for the semiconductor device according to the present invention is usually cut from a single crystal of gallium arsenide, or gallium arsenide containing from $1 \times 10^{18}$ to $1 \times 10^{21}$ $cm^{-3}$ of indium, indium arsenide, and indium phosphide, or the like, since the mobility of carriers of these single crystals is high and semiconductor devices able to operate at a high frequency or a high speed can be easily manufactured by using these single crystals. Among these single crystals of III-V compounds, the single crystals of gallium arsenide and gallium arsenide containing indium are preferred, since single crystals with a large diameter and having an excellent crystallinity can be easily produced therefrom.

The single crystalline substrate of the III-V compound used in the present invention must be semi-insulating, since otherwise, the electrodes and the respective components of a device are not satisfactorily electrically isolated from each other. The term "semi-insulating" herein denotes a resistivity of $1 \times 10^{7}$ $\Omega \cdot cm$ or more.

According to a usual FEC method for producing the substrate, a single crystal of the III-V compound is grown by a liquid-encapsulated, Czochralsky method, (hereinafter referred to as the "LEC" method) and is then cut to produce substrates with surfaces having a required plane-orientation, e.g., {100} plane. The quartz container and other appliances which are used in the boat growth methods, e.g., the horizontal Bridgeman method, or gradient freeze method, are not used in the LEC method and, therefore, it is possible to prevent the contamination of conductive impurities, e.g., silicon and the like, into a single crystal. As a result, semi-insulating single crystals of the III-V compound, free of conductive impurities, i.e., undoped, semi-insulating single crystals of the III-V compound, can be easily grown. The semi-insulating single crystals of the III-V compound may be the undoped single crystals as described above or may be doped with compensating impurities at a deep level, such as chromium, iron, and nickel. The undoped single crystals are more preferable than the doped single crystals, since variations in the characteristics occur in the latter crystals due to thermal diffusion of the compensating impurities during annealing.

The boron concentration of a single crystalline substrate of the III-V compound must not exceed $1 \times 10^{17}$ cm$^{-3}$, because if the boron concentration exceeds $1 \times 10^{17}$ cm$^{-3}$, the activation ratio of implanted impurities is disadvantageously variable and low. Preferably, the boron concentration does not exceed 9 $\times 10^{16}$ cm$^{-3}$, more preferably $3 \times 10^{16}$ cm$^{-3}$, most preferably $1 \times 10^{16}$ cm$^{-3}$.

In the growth by the ordinary LEC method, the reaction between the diboron trioxide used as the encapsulant or the pyrolitic boron nitride used as the crucible material and the melt of the III-V compound takes place to an extent such that the concentration of boron incorporated into the melt and then included in the resultant single crystal exceeds $1 \times 10^{17}$ cm$^{-3}$. Preferably, to suppress the boron intrusion from the encapsulant and thus attain the boron concentration of the III-V compound not exceeding $1 \times 10^{17}$ cm$^{-3}$, the oxide(s) of the IIIb group element and/or Vb group element is added at a concentration of oxygen atoms in the range of from $1 \times 10^{17}$ to $2 \times 10^{21}$ cm$^{-3}$ to the melt for the growth of a single crystalline III-V compound.

This growth method is disclosed in Japanese Unexamined Patent Publication Nos. 61-155296, and 61-178497, British patent application No. 8609480 and U.S. Patent application, S.N. 854,045. Alternatively, the diboron trioxide containing from 100 to 300 ppm by weight of water may be used as the encapsulant for the growth of a single crystal.

The ion implantation can be carried out by the ordinary method and is not limited, but the ion-implantation amount is preferably in the range of from $1 \times 10^{11}$ to $1 \times 10^{15}$ $cm^{-2}$, more preferably in the range of from $5 \times 10^{11}$ to $5 \times 10^{13}$ $cm^{-2}$. The conductive impurity ions subjected to the ion implantation are silicon, sulfur, selenium, tellurium and the like as the n-type impurities, and magnesium, beryllium, zinc, cadmium, and the like as the p-type impurities. After the ion implantation, annealing is carried out to electrically activate the implanted impurity ions and to recover the damage caused by the ion implantation in the substrate. The activation ratio or ratio of activation herein is the value obtained by dividing the quantity of electrically activated impurity ions, from which the carriers are generated, by the quantity of impurity ions implanted.

The annealing according to the present invention may be carried out by any one of the capless method, in which the substrate is annealed in the gas atmosphere containing a Vb group element, and the cap anneal method, in which a substrate is covered by a dense film of silicon nitride, silicon oxide, aluminum oxide, silicon oxynitride, and the like over the surfaces thereof and is then annealed. Ordinary conditions for annealing other than described above may be used.

The semiconductor devices according to the present invention may be a Schottky barrier diode, a Gunn diode, a Hall device, a field effect transistor, a digital IC, analog IC, and the like. These semiconductor devices are fabricated, after completion of the annealing, by forming electrodes on a substrate, dividing the substrate into chips, and, bonding lead wires on each chip.

The semiconductor devices are then packaged.

The present invention attains the following industrial advantages.

(1) The dispersion of activation ratio of implanted impurity ions in a semiconductor device according to the present invention is as low as $1/10 \sim 2/3$ times that of a conventional device, and accordingly, the dispersion in the properties of the semiconductor devices is greatly reduced.

(2)  Even when using a substrate cut from a single crystal produced by the FEC method, and thus having a low etch pit density, the activation ratio dispersion is 2/3 times lower than the conventional substrate. Therefore, the dispersion in the properties of semiconductor devices is greatly reduced.

(3)  The activation ratio is enhanced by 2 to 4 times over the conventional ratio, and the properties of semiconductor devices, for example, the mutual conductance of field effect transistors, are greatly enhanced.

The present invention is further explained with reference to Examples and Comparative Examples. In the following Examples and Comparative Examples, the activation ratio is indicated by the percentage value obtained by dividing the sheetcarrier concentration by the amount of impurities implanted, and the dispersion of the activation ratio is indicated by a percentage value which is obtained by dividing the standard deviation ($\sigma$) by the average value ($\bar{x}$) of the activation ratio. In addition, the dispersion of the threshold voltage (Vth) of the field effect transistors is indicated by the standard deviation ($\sigma$).

Example 1  (Fabrication of Hall Devices)

An undoped, semi-insulating, single crystalline gallium arsenide having a diameter of 5 cm was used. The substrate had a boron concentration of $8 \times 10^{15}$ $cm^{-3}$, resistivity of $5 \times 10^{7}$ $\Omega \cdot cm$, average, etch-pit density of $1.1 \times 10^{4}$ $cm^{-2}$, and a (100) plane surface orientation. On the entire surface of a substrate, $^{29}Si^{+}$ ions were implanted at an implantation energy of 60 keV and an implantation amount of $5.0 \times 10^{12}$ $cm^{-2}$.

After the completion of ion-implantation, the substrate was subjected to annealing, in which the substrate was held at 820°C for 10 minutes in an arsine atmosphere diluted by hydrogen (the partial pressure of arsine being 3 mmHg). After completion of the annealing, the electrodes-pattern of a Hall device was formed on the substrate by photolithography using photo-resist, and then gold-germanium alloy was vapor-deposited thereon. The film of photo-resist was then lifted off, followed by alloying to form electrodes. Mesa-etching was then carried out to separate the 7200 Hall devices having a size of 0.50 mm square from each other.

The measurements by the Van der pauw method were carried out, and the following results were obtained.

(1)  Sheet carrier concentration:  $2.10 \times 10^{12}$ $cm^{-2}$ on average

(2)  Activation ratio:  42% with dispersion of 4.5%

(3)  Mobility:  4100 $cm^2/V \cdot sec$

Example 2

In order to investigate the variations in activation ratio between lots, the ion-implantation experiments were repeated five times under the same conditions as in Example 1.

As a result, the activation ratio ranged from 41 to 44%.

Example 3   (Fabrication of Field Effect Transistors)

The substrate cut from the same single crystal as that used for the substrate in Example 1 was used. The boron concentration, resistivity and etch pit density were the same as in Example 1. The channel, source, and drain patterns were delineated on the substrate by photo-lithography. The implantation of $29Si^{+}$ ions was carried out in two steps. In the first step the ions were implanted in the channel under the conditions of an implantation energy of 50 keV, and an implantation amount of $1.3 \times 10^{12}$ $cm^{-2}$. In the second step, the ions were implanted into the source and drain parts, when the electrodes are to be formed, under the conditions an implantation energy of 150 KeV and an implantation

amount of $2 \times 10^{13}$ cm$^{-2}$, and an excellent ohmic contact was obtained.

After completion of the ion implantation, annealing was carried out under the same conditions as in Example 1. The patterns for the source- and drain-electrodes were formed on the substrate by photolithography using a photo-resist, followed by the vapor deposition of gold-germanium alloy. The photo-resist film was then a lifted off and the source and drain electrodes were formed by the alloying process. Subsequently, platinum was vapor-deposited on a part of the substrate to form the gate, i.e., to form a Schottky-barrier gate. By the process as described above, 7200 field effect transistors were formed on the substrate at a distance of 0.50 mm therebetween. The gate length and the gate width of the fabricated field effect transistors were 1 μm and 20 μm, respectively. The threshold voltage (Vth), dispersion thereof, and mutual conductance (gm) were as follows.

(1) Vth: 0.004 V on average dispersion: 40 mV

(2) gm: 80 mS/mm

Example 4 (Fabrication of Hall Devices)

A semi-insulating, single crystalline gallium arsenide containing $1 \times 10^{20}$ cm$^{-3}$ of indium and having a diameter of 5 cm, which was grown by FEC method, was used. The substrate had a boron concentration of $8 \times 10^{16}$ cm$^{-3}$, resistivity of $3.0 \times 10^{7}$ Ω·cm, average etch-pit density of 150 cm$^{-2}$, and a (100) plane surface orientation. 7200 Hall devices at a distance of 0.5 mm were fabricated by using the above substrate and the same method as in Example 1.

The measurements by the Van der Pauw method were then carried out and the following results were obtained.

(1) Sheet carrier-concentration: $1.3 \times 10^{12}$ cm$^{-2}$ on average

(2) Activation ratio: 26% with dispersion of 2.0%

(3) Mobility: 4200 $cm^2$/V·sec

Example 5 (Fabrication of Field Effect Transistors)

The substrate cut from the same single crystal as that used for the substrate in Example 4 was used. The boron concentration, resistivity and etch pit density were the same as in Example 4. By the process as described in Example 3, 7200 field effect transistors were formed on the substrate at a distance of 0.50 mm therebetween. The gate length and the gate width of the fabricated field effect transistors were 1 μm and 20 μm, respectively. The threshold voltage (Vth), dispersion thereof, and mutual conductance (gm) were as follows.

(1) Vth: 0.80V on average dispersion 15mV

(2) gm: 78mS/mm

Example 6 (Fabrication of Hall Devices)

A semi-insulating, single crystalline gallium arsenide containing $1 \times 10^{20}$ $cm^{-3}$ of indium and having a diameter of 5 cm which was grown by FEC method, was used. The substrate had a boron concentration of $9 \times 10^{16}$ $cm^{-3}$, resistivity of $3.0 \times 10^{7}$ Ω·cm, average etch-pit density of 150 $cm^{-2}$, and a (100) place surface orientation. 7200 Hall devices at a distance of 0.5 mm were fabricated by using the above substrate and the same method as in Example 1.

The measurements by the Van der pauw method were then carried out and the following results were obtained.

(1) Sheet carrier-concentration: $1.2 \times 10^{12}$ $cm^{-2}$ on average

(2) Activation ratio: 24% with dispersion of 2.0%

(3) Mobility: 4200 $cm^2$/V·sec

Example 7 (Fabrication of Field Effect Transistors)

The substrate cut from the same single crystal as that used for the substrate in Example 6 was used. The boron concentration, resistivity and etch pit density were the same as in Example 6. By the process as described in Example 3, 7200 field effect transistors were formed on the substrate at a distance of 0.50 mm therebetween. The gate length and the gate width of the field effect transistors were 1 μm and 20 μm, respectively. The threshold voltage, dispersion thereof, and mutual conductance (gm) were as follows.

(1) Vth: -0.75 V on average dispersion: 15 mV

(2) gm: 76 mS/mm

Comparative Example 1 (Fabrication of Hall Devices)

An undoped, semi-insulating, single crystalline gallium arsenide having a diameter of 5 cm was used. The substrate had a boron concentration of $2.5 \times 10^{17}$ $cm^{-3}$, resistivity of $4 \times 10^{7}$ Ω·cm, average etch-pit density of $1.2 \times 10^{4}$ $cm^{-2}$, and a (100) plane surface orientation. The Hall devices were fabricated as in Example 1.

The measurements by the Van der Pauw method were then carried out and the following results were obtained.

(1) Sheet carrier-concentration: $8.1 \times 10^{11}$ $cm^{-2}$ on average

(2) Activation ratio: 16% with dispersion of 14%

(3) Mobility: 3900 $cm^2$/V·sec

Comparative Example 2

In order to investigate the variation in activation ratio between lots, the ion-implantation experiments were repeated five times under the same conditions as in Example 1.

As a result, the activation ratio ranged from 13 to 17%.

Comparative Example 3

The same gallium arsenide-, single crystalline substrate as used in Comparative Example 1 was used to produce, as in Example 3, 7200 field effect transistors. The properties of the fabricated field effect transistors were as follows.

(1) Vth: 0.21 V on average and 124 mV in dispersion

(2)   gm:   44 mS/mm

Comparative Example 4   (Fabrication of Hall Devices)

An undoped, semi-insulating, single crystalline gallium arsenide containing $1 \times 10^{20} cm^{-3}$ of indium and having a diameter of 5 cm was used.  The substrate had a boron concentration of $3.0 \times 10^{17} cm^{-3}$, resistivity of $3.5 \times 10^{7}$ Ω·cm, average etch-pit density of 60 $cm^{-2}$ and a (100) plane surface orientation.  The Hall devices were fabricated as in Comparative Example 1.

The measurements by the Van der Pauw method were then carried out and the following results were obtained.

(1)   Sheet carrier-concentration:   $8.8 \times 10^{11} cm^{-2}$ on average

(2)   Activation ratio:   17.6% with dispersion of 3.5%

(3)   Mobility:   3850 $cm^{2}$/V·sec

Comparative Example 5   (Fabrication of Field Effect Transistors)

The substrate cut from the same single crystal as that used for the substrate in Comparative Example 4 was used.  The boron concentration, resistivity and etch pit density were the same as in Comparative Example 4.  By the process as described in Example 3, 7200 field effect transistors were formed.  The properties of the field effect transistors were as follows.

(1)   Vth:   0.19 V on average
           dispersion:   25 mV

(2)   gm:   46 mS/mm

Comparative Example 6   (Fabrication of Hall Devices)

A semi-insulating, single crystalline gallium arsenide containing $1 \times 10^{20} cm^{-3}$ of indium and having a diameter of 5 cm was used.  The substrate had a boron concentration of $2.0 \times 10^{17} cm^{-3}$, resistivity of 3.5 $\times 10^{7}$ Ω·cm, average etch-pit density of 60 $cm^{-2}$, and a (100) plane surface orientation.  7200 Hall devices at a distance of 0.5 mm were fabricated as in Example 1.

The measurements by the Van der Pauw method were then carried out and the following results were obtained.

(1)  Sheet carrier-concentration of:  1.0 x $10^{12}$ $cm^{-2}$ on average

(2)  Activation ratio:  20% with dispersion of 3.5%

(3)  Mobility:  3850 $cm^2$/V·sec

Comparative Example 7  (Fabrication of Field Effect Transistors)

The substrate cut from the same single crystal as that used for the substrate in Comparative Example 6 was used.  The boron concentration, resistivity and etch pit density were the same as in Comparative Example 6.  By the process as described in Example 3, 7200 field effect transistors were formed.  The properties of the field effect transistors were as follows.

(1)  Vth:  0.10 V on average dispersion:  25 mV

(2)  gm:  46 mS/mm

As apparent from the above Examples and Comparative Examples, the activation ratio is high and uniform when a single crystalline substrate of the III-V compound is used, in which the boron concentration does not exceed 1 x $10^{17}$ $cm^{-3}$, compared with the use of a substrate with a boron concentration exceeding 1 x $10^{17}$ $cm^{-3}$.  The properties of a semiconductor device obtained by using the former substrate are therefore improved and uniform.

## CLAIMS

1. A semiconductor device comprising a single crystalline substrate of a semi-insulating compound consisting of a IIIb-group element and a Vb-group element of the Periodic Table and regions of the single crystalline substrate with conductive impurities which are ion-implanted and then activated by annealing, characterized in that the concentration of boron contained in the single crystalline substrate does not exceed $1 \times 10^{17}$ cm$^{-3}$.

2. A semiconductor device according to claim 1, wherein said boron concentration does not exceed $9 \times 10^{16}$ cm$^{-3}$.

3. A semiconductor device according to claim 2, wherein the boron concentration does not exceed $3 \times 10^{16}$ cm$^{-3}$.

4. A semiconductor device according to claim 3, wherein the boron concentration does not exceed $1 \times 10^{16}$ cm$^{-3}$.

5. A semiconductor device according to any one of claims 1 to 4, wherein the compound consisting of the IIIb group element and Vb group element of the Periodic Table is gallium arsenide.

6. A semiconductor device according to any one of claims 1 to 4, wherein the compound consisting of the IIIb group element and Vb group element is gallium arsenide containing from $1 \times 10^{18}$ cm$^{-3}$ to $1 \times 10^{21}$ cm$^{-3}$ of indium.

7. A semiconductor device according to any one of claims 1 through 6, wherein the concentration of implanted conductive impurities is from $1 \times 10^{11}$ to $1 \times 10^{15}$ cm$^{-2}$.

8. A semiconductor device according to claim 7, wherein the concentration of conductive impurities is from $5 \times 10^{11}$ to $5 \times 10^{13}$ cm$^{-2}$.

9. A semiconductor device according to any one of claims 1 through 8, wherein said substrate is cut from a single crystal produced by a liquid encapsulated method.